# EUROPEAN PATENT APPLICATION

(11) **EP 2 330 639 A1**
(43) Date of publication of application: **08.06.2011**
(21) Application number: 08877018.5
(22) Date of filing: 28.09.2008
(51) Int. Cl.: H01L 33/00

(54) **AN ALTERNATING CURRENT OF LED MODULE**

(71) Applicant: Chang, Yihui, Taiwan 30049 (CN)
(72) Inventor: CHANG, Yi-Hui,, 30049 Hsinchu City Taiwan, R.O.C. (CN); HAO, Ching-Chien,, 30049 Hsinchu City, Taiwan, R.O.C. (TW)
(74) Representative: Reichert, Sabine
(86) International application number: PCT/CN2008/001689
(87) International publication number: WO 2010/034139

(57) **Abstract**

The present invention relates to an alternating current driven light emitting diode module. The alternating current driven light emitting diode module includes an alternating current driven light emitting diode chip, a first thermal conduction plate, and a ceramic substrate. The first thermal conduction plate is arranged on the ceramic substrate. The alternating current driven light emitting diode chip is arranged on the first thermal conduction plate. The alternating current driven light emitting diode module has better heat dissipating property and better insulation property.

## Description

### FIELD OF THE INVENTION

The present invention relates to a light emitting diode module, and more particularly to a light emitting diode module driven by alternating current.

### BACKGROUND OF THE INVENTION

Light Emitting Diode (LED) is a solid semiconductor light emitting device. The LED produces photons and thus emits light by electron-hole pair recombination. The LED has advantages of high luminous efficiency, small size, long life, and low pollution, and has broad application prospects in illumination devices, back light modules, and display devices, etc.

The LEDs can be divided into direct current (DC) driven LEDs and alternating current (AC) driven LEDs with respect to different drive modes of the LED chips.

Because the DC driven LEDs is necessary to be driven by direct current, an external circuit such as an inverter is provided and used to transform alternating current in daily power environment into direct current. However, the external circuit increases manufacturing cost, and takes up space, thus resulting in difficulty in minimizing size of the DC driven LEDs. In addition, heat generated by the external circuit increases the burden for heat dissipation function of the LEDs, thus shortening lifespan of the DC driven LEDs.

Generally, AC driven LED modules refers to LEDs which can be used by directly connecting to an alternating current voltage. The AC driven LED modules can be directly used without provision of the external circuit such as the inverter, and the AC driven LED modules can be operated by applying low current. Compared to the DC driven LEDs, the AC driven LED modules have advantages of small size, cost efficiency, and long life. In recent years, application and research of the AC driven LED modules are brought into spotlight.

However, heat dissipating efficiency of the AC driven LED modules is ordinary. When the AC driven LEDs generate relatively more heat, the heat is difficult to be dissipated timely and quickly, thus lifespan and reliability of the AC driven LED modules are negatively affected.

### SUMMARY OF THE INVENTION

Considering shortcomings of the conventional AC driven LED modules, the inventor of the present invention is actively doing research and making innovation, and is expecting to design an AC driven LED module with novel structure, based on many years of experience and expertise in designing and manufacturing similar products, and with the use of academic theory. The AC driven LED module in the present invention is carried out by improving the conventional AC driven LED module to have practical applicability. Through continuous research, design, and repeatedly test and improvement, the present AC driven LED module with practical value is finally carried out.

One object of the present invention is to overcome the conventional shortcomings of the conventional AC driven LED modules and provide an AC driven LED module with novel structure. The AC driven LED module in the present invention has better heat dissipating efficiency and insulation property than before.

The object of the present invention is achieved by the following technical solution, in which an AC driven LED module is provided. The AC driven LED module includes an AC driven LED chip, a first thermal conduction plate, and a ceramic substrate. The LED chip is driven by alternating current. The first thermal conduction plate is arranged on the ceramic substrate. The AC driven LED chip is arranged on the first thermal conduction plate.

The object of the present invention is further achieved by the following technical solutions.

The AC driven LED module as described above, wherein material of the ceramic substrate is aluminum oxide or aluminum nitride.

The AC driven LED module as described above, wherein the AC driven LED module further includes a thermal conduction bar. An end of the thermal conduction bar is connected to the first thermal conduction plate. An opposite other end of the thermal conduction bar extends into the ceramic substrate. Material of the first thermal conduction plate and the thermal conduction bar is metal, such as aluminum or copper.

The AC driven LED module as described above, wherein the first thermal conduction plate and the thermal conduction bar are integrally manufactured and connected to each other, or are fixedly attached to each other via welding or screwing.

The AC driven LED module as described above, wherein the ceramic substrate includes a bottom surface, a top surface opposite to the bottom surface, and a connection hole defined in the top surface and extending into the ceramic substrate. The first thermal conduction plate is arranged on the top surface. The thermal conduction bar extends into the ceramic substrate by cooperating with the connection hole.

The AC driven LED module as described above, wherein a thermal adhesive is provided and filled between the thermal conduction bar and a sidewall of the connection hole.

The AC driven LED module as described above, wherein the ceramic substrate includes a bottom surface, a top surface opposite to the bottom surface, and a connection hole defined in the top surface and extending through the bottom surface. The first thermal conduction plate is arranged on the top surface. The connection hole is a step hole. A portion of the hole with wider diameter is located adjacent to bottom surface. The thermal conduction bar is moved toward the bottom surface and inserted into the connection hole, and is further connected to the first thermal conduction plate after inserted into the connection hole.

The AC driven LED module as described above, wherein a thermal adhesive is provided and filled between the thermal conduction bar and a sidewall of the connection hole.

The AC driven LED module as described above, wherein the AC driven LED module further includes a thermal conduction bar. An end of the thermal conduction bar is connected to the first thermal conduction plate. The ceramic substrate is formed on the first thermal conduction plate and covers an opposite other end of the thermal conduction bar by injection molding.

The AC driven LED module as described above, wherein the end of the thermal conduction bar covered by the ceramic substrate includes a thermal diffusion portion.

The AC driven LED module as described above, wherein the thermal diffusion portion covered by the ceramic substrate is bent.

The AC driven LED module as described above, wherein the AC driven LED module further includes a second thermal conduction plate. The ceramic substrate includes a top surface, a bottom surface opposite to the top surface, and a peripheral surface located between and adjoining the top surface and the bottom surface. The first thermal conduction plate is arranged on the top surface. The second thermal conduction plate is arranged adjacent to the bottom surface or the peripheral surface. The thermal conduction bar is connected to the first thermal conduction plate and the second thermal conduction plate. Material of the first thermal conduction plate, the thermal conduction bar, and the second thermal conduction plate is metal, such as aluminum or copper.

The AC driven LED module as described above, wherein the first thermal conduction plate, the second thermal conduction plate, and the thermal conduction bar are integrally manufactured and connected to one another, or are fixedly attached to each other via welding or screwing.

The present invention has apparent advantages and beneficial effects compared to the conventional technologies. Based on the technical solution described above, the AC driven LED module of the present invention at least has the advantages and beneficial effects as follows:

The AC driven LED module as described above, as the ceramic substrate has better heat dissipating property, thus heat, which is generated by the AC driven LED chip and transferred to the ceramic substrate through the first thermal conduction plate, can be quickly dissipated to ambient environment by the ceramic substrate. In addition, as the AC driven LED module further includes a thermal conduction bar, and the thermal conduction bar has better thermal conductive property, shortage of insufficient thermal conductive property of the ceramic substrate can be compensated by the thermal conduction bar. Speed of the heat, which is generated by the AC driven LED chip, transferring from the AC driven LED chip to the ceramic substrate is accelerated, thus heat dissipating efficiency of the AC driven LED is further increased.

The above mentioned object and other objects, features, and advantages of the present invention can be better understood with reference to the following embodiments and drawings.

In summary, the present invention relates to an AC driven LED module. The AC driven LED module includes an AC driven LED chip, a first thermal conduction plate, and a ceramic substrate. The first thermal conduction plate is arranged on the ceramic substrate. The AC driven LED chip is arranged on the first thermal conduction plate. The AC driven LED module has advantages of better heat dissipating property and better insulation property. The present invention has many advantages and many practical values described above, either structure or function of the product is improved a lot. In addition, the present invention makes significant technical progress, and produces useful and practical results. Furthermore, the present invention has outstanding technical effect compared to the conventional AC driven LED module, and is more suitable for practical use. The present invention truly is a novel, unobvious, and practical design.

It is understood that the exemplary embodiments described above is summary of technical solution of the present invention. For clearly understanding the technical solution of the present invention, thus facilitating application of the present invention according to the specification, and also for clearly understanding the above mentioned object and other objects, features, and advantages of the present invention, embodiments and drawings are provided, as follows.

### BRIEF DESCRIPTION OF THE DRAWINGS

The above objects and advantages of the present invention will become more readily apparent to those ordinarily skilled in the art after reviewing the following detailed description and accompanying drawings, in which:

FIG. 1 is schematic cross section of an AC driven LED module in accordance with a first embodiment of the present invention.

FIG. 2 is schematic cross section of an AC driven LED module in accordance with a second embodiment of the present invention.

FIG. 3 is schematic cross section of an AC driven LED module in accordance with a third embodiment of the present invention.

FIG. 4 is schematic cross section of an AC driven LED module in accordance with a fourth embodiment of the present invention.

FIG. 5 is schematic cross section of an AC driven LED module in accordance with a fifth embodiment of the present invention.

FIG. 6 is schematic cross section of an AC driven LED module in accordance with a sixth embodiment of the present invention.

FIG. 7 is schematic cross section of an AC driven LED module in accordance with a seventh embodiment of the present invention.

FIG. 8 is schematic cross section of an AC driven LED module in accordance with an eighth embodiment of the present invention.

### DETAILED DESCRIPTION OF THE INVENTION

For clearly illustration of technical solution and beneficial effect for achieving the object of the present invention, embodiments, structures, features, and beneficial effects of the present invention are described, as follows.

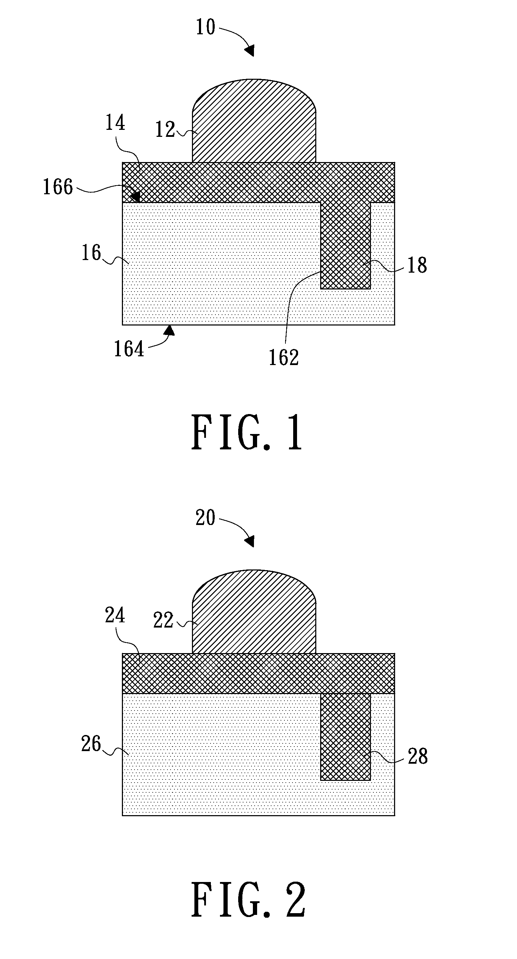

FIG. 1 is schematic cross section of an AC driven LED module in accordance with a first embodiment of the present invention. An AC driven LED module 10 in accordance with the first embodiment includes an AC driven LED chip 12, a first thermal conduction plate 14, and a ceramic substrate 16. The first thermal conduction plate 14 is arranged on the ceramic substrate 16. The LED chip 12 is arranged on the first thermal conduction plate 14. The first thermal conduction plate 14 is made of material with better thermal conductive property, such as metallic material. The ceramic substrate 16 is made of ceramic material with better heat dissipating property, such as aluminum oxide, aluminum nitride, or silicon carbide.

In this embodiment, the AC driven LED module 10 further includes a thermal conduction bar 18. The thermal conduction bar 18 and the first thermal conduction plate 14 are integrally manufactured and connected to each other. Similar to the first thermal conduction plate 14, the thermal conduction bar 18 is made of material with better thermal conductive property, for example metal, such as aluminum or copper. In this embodiment, the thermal conduction bar 18 is made of aluminum, thus the thermal conduction bar 18 is cost efficient. It is noted that material of the thermal conduction bar 18 and material of the first thermal conduction plate 14 can be same as each other, or different from each other. Preferably, material of the thermal conduction bar 18 is same as material of the first thermal conduction plate 14, thus the thermal conduction bar 18 and the first thermal conduction plate 14 can be easily integrally manufactured and connected to each other. The ceramic substrate 16 includes a bottom surface 164, a top surface 166 opposite to the bottom surface 164, and a connection hole 162. The first thermal conduction plate 14 is arranged on the top surface 166. The connection hole 162 is defined in the top surface 166, and extends into the ceramic substrate 16 but does not extend through the bottom surface 164. An end of the thermal conduction bar 18 distant from the first thermal conduction plate 14 is shaped to cooperate with the connection hole 162. That is, the thermal conduction bar 18 extends inside the ceramic substrate 16 by cooperating with the connection hole 162.

In use, as the ceramic substrate 16 has better heat dissipating property, thus heat, which is generated by the AC driven LED chip 12 and transferred to the ceramic substrate 16 through the first thermal conduction plate 14, can be quickly dissipated. The ceramic substrate 16 may has porous structure, for example. When the ceramic substrate 16 is exposed in the air, the air can be introduced into an interior of the ceramic substrate 16 through holes of the ceramic substrate 16, thus creating thermal convection inside the ceramic substrate 16. The air can be exhausted out of the ceramic substrate 16 by thermal convection to dissipate heat inside the ceramic substrate 16. In this manner, heat generated by the AC driven LED chip 12 can be quickly transferred to the ceramic substrate 16, and further dissipated to an exterior of the AC driven LED module 10 by thermal convection. Thus, heat dissipating efficiency of the AC driven LED module 10 is increased, lifespan of the AC driven LED module 10 is elongated, and reliability of the AC driven LED module 10 is enhanced. In addition, the AC driven LED module 10 might further include the thermal conduction bar 18 as in the embodiment. The thermal conduction bar 18 has better thermal conductive property, and is used to increase a surface area of the ceramic substrate 16 for transferring heat generated by the AC driven LED 12. Thus, speed of the heat transferred to the ceramic substrate 16 is accelerated, heat dissipating efficiency of the AC driven LED module 10 is further increased.

**FIG. 2** is schematic cross section of an AC driven LED module in accordance with a second embodiment of the present invention. The AC driven LED module 20 of the second embodiment in the present invention is similar to the AC driven LED module 10, and includes an AC driven LED chip 22, a first thermal conduction plate 24, a ceramic substrate 26, and a thermal conduction bar 28. The AC driven LED module 20 differs from the AC driven LED module 10 in that the thermal conduction bar 28 and the first thermal conduction plate 24 are fixedly attached to each other via welding.

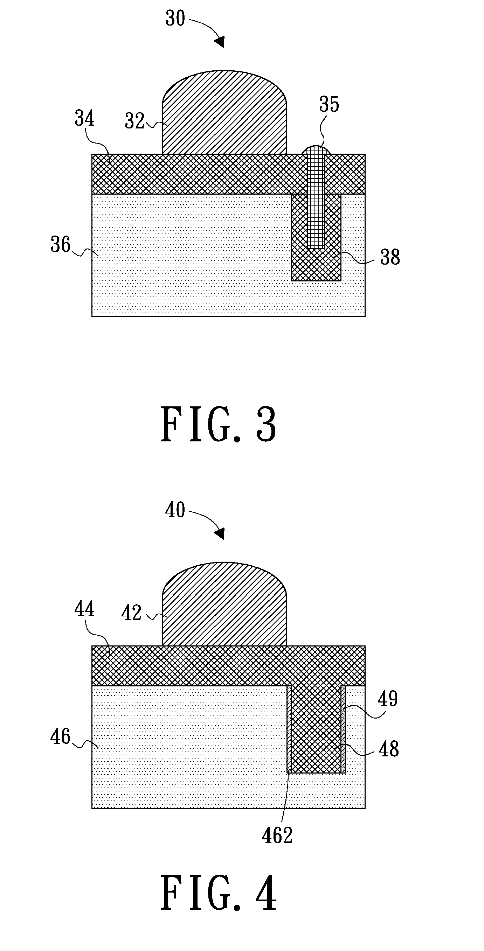

**FIG. 3** is schematic cross section of an AC driven LED module in accordance with a third embodiment of the present invention. The AC driven LED module 30 of the third embodiment in the present invention is similar to the AC driven LED module 10, and includes an AC driven LED chip 32, a first thermal conduction plate 34, a ceramic substrate 36, and a thermal conduction bar 38. The AC driven LED module 30 differs from the AC driven LED module 10 in that the thermal conduction bar 38 and the first thermal conduction plate 34 are fixedly attached to each other via a screw 35.

**FIG. 4** is schematic cross section of an AC driven LED module in accordance with a fourth embodiment of the present invention. The AC driven LED module 40 of the fourth embodiment in the present invention is similar to the AC driven LED module 10, and includes an AC driven LED chip 42, a first thermal conduction plate 44, a ceramic substrate 46, and a thermal conduction bar 48. The AC driven LED module 40 differs from the AC driven LED module 10 in that a thermal adhesive 49 is provided and filled between the thermal conduction bar 48 and a sidewall of the connection hole 462. As the thermal conduction bar 48 and the sidewall of the connection hole 462 is filled with the thermal adhesive 49, atmosphere remained between the thermal conduction bar 48 and the sidewall of the connection hole 462 can be squeezed out of the connection hole 462. Thermal resistant between the thermal conduction bar 48 and the ceramic substrate 46 is reduced. In this manner, heat dissipating efficiency of the AC driven LED module 40 is accordingly increased.

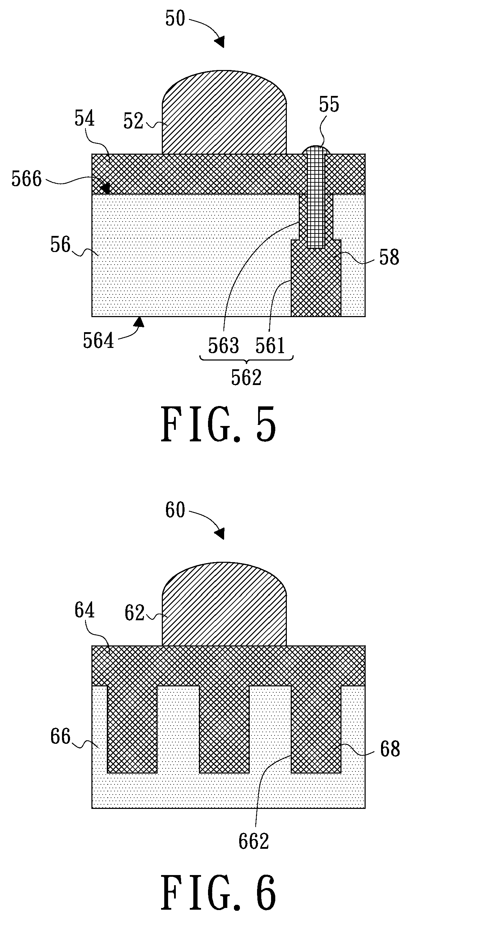

**FIG. 5** is schematic cross section of an AC driven LED module in accordance with a fifth embodiment of the present invention. The AC driven LED module 50 of the fifth embodiment in the present invention is similar to the AC driven LED module 10, and includes an AC driven LED chip 52, a first thermal conduction plate 54, a ceramic substrate 56, and a thermal conduction bar 58. The ceramic substrate 56 includes a bottom surface 564, a top surface 566 opposite to the bottom surface 564, and a connection hole 562. The AC driven LED module 50 differs from the AC driven LED module 10 in that the connection hole 562 is a step hole, and the connection hole 562 extends through both of the bottom surface 564 and the top surface 566. The connection hole 562 includes a first hole portion 561 and a second hole portion 563. The second hole portion 563 is close to the bottom surface 564, and the first hole portion 561 is farther from the bottom surface 564. A diameter of the second hole portion 563 is greater than that of the first hole portion 561. In assembly, the thermal conduction bar 58 can be moved toward the bottom surface 564 and inserted in the connection hole 562, and then fixedly attached to the first thermal conduction plate 54 via a screw 55. As the thermal conduction bar 58 can be moved toward the bottom surface 564 first and then inserted in the connection hole 562, thus the thermal conduction bar 58 can be assembled after the AC driven LED chip 52, the first thermal conduction plate 54, and the ceramic substrate 56 are assembled together. Therefore, assembly of the AC driven LED module 50 is quite convenient. In addition, a wider portion of the thermal conduction bar 58 corresponding to the connection hole 562 is located at a side of the thermal conduction bar 58 close to the bottom surface 564. With this configuration, the thermal conduction bar 58 can be used to quickly transfer more heat to a portion the ceramic substrate 56 close to the bottom surface 564. Heat dissipating efficiency of the AC driven LED module 50 thus is further increased. It is noted a thermal adhesive (not shown) also can be provided and filled between the thermal conduction bar 58 and a sidewall of the connection hole 562.

**FIG. 6** is schematic cross section of an AC driven LED module in accordance with a sixth embodiment of the present invention. The AC driven LED module 60 of the sixth embodiment in the present invention is similar to the AC driven LED module 10, and includes an AC driven LED chip 62, a first thermal conduction plate 64, a ceramic substrate 66, and a number of thermal conduction bars 68. The ceramic substrate 66 defines a number of connection holes 662. The AC driven LED module 60 differs from the AC driven LED module 10 in that the AC driven LED module 60 includes a number of the connection holes 662 and a number of the thermal conduction bars 68.

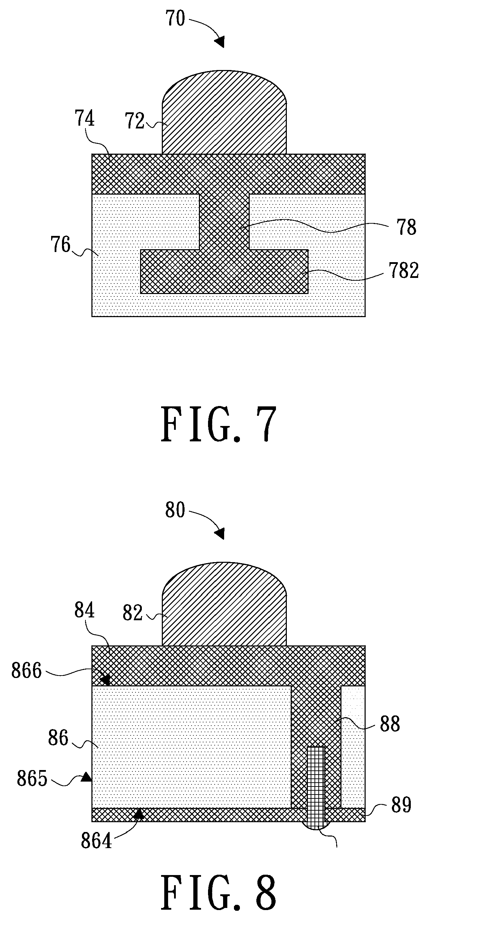

**FIG. 7** is schematic cross section of an AC driven LED module in accordance with a seventh embodiment of the present invention. The AC driven LED module 70 of the seventh embodiment in the present invention is similar to the AC driven LED module 10, and includes an AC driven LED chip 72, a first thermal conduction plate 74, a ceramic substrate 76, and a thermal conduction bar 78. The AC driven LED module 70 differs from the AC driven LED module 10 in that the ceramic substrate 76 is formed on the first thermal conduction plate 74 by injection molding. The ceramic substrate 76 covers the thermal conduction bar 78, and is arranged at a side of the first thermal conduction plate 74 facing away from the AC driven LED chip 72. In addition, an end of the thermal conduction bar 78 covered by the ceramic substrate 76 includes a thermal diffusion portion 782. The thermal diffusion portion 782 is used to increase a surface area of the thermal conduction bar 78 in the ceramic substrate 76 contacting the ceramic substrate 76. The thermal diffusion portion 782 can be bent. As the ceramic substrate 76 covers the thermal conduction bar 78 by injection molding, the thermal conduction bar 78 intimately contacts the ceramic substrate 76 to avoid air layer formed between the thermal conduction bar 78 and the ceramic substrate 76. Thus, thermal resistant between the thermal conduction bar 78 and the ceramic substrate 76 can be reduced. Heat dissipating efficiency of the AC driven LED module 70 is accordingly increased. Furthermore, as the end of the thermal conduction bar 78 covered by the ceramic substrate 76 includes the thermal diffusion portion 782, heat can be accelerated to be dispersed in the ceramic substrate 76. Accordingly, heat dissipating property of the ceramic substrate 76 can be fully used. Thus, heat dissipating efficiency of the AC driven LED module 70 is further increased.

**FIG. 8** is schematic cross section of an AC driven LED module in accordance with an eighth embodiment of the present invention. The AC driven LED module 80 of the eighth embodiment in the present invention is similar to the AC driven LED module 10, and includes an AC driven LED chip 82, a first thermal conduction plate 84, a ceramic substrate 86, and a thermal conduction bar 88. The AC driven LED module 80 differs from the AC driven LED module 10 in that the AC driven LED module 80 further includes a second thermal conduction plate 89. The ceramic substrate 86 includes a top surface 866, a bottom surface 864 opposite to the top surface 866, and a peripheral surface 865. The peripheral surface 865 is located between and adjoins the top surface 866 and the bottom surface 864. The first thermal conduction plate 84 is arranged on the top surface 866. The second thermal conduction plate 89 is arranged below and contacts the bottom surface 864. The thermal conduction bar 88 is connected to the first thermal conduction plate 84 and the second thermal conduction plate 89. In detail, the first thermal conduction plate 84 and the thermal conduction bar 88 are integrally manufactured and connected to each other. The second thermal conduction plate 89 and the thermal conduction bar 88 are fixedly attached to each other by a screw 85. In alternative embodiments, the second thermal conduction plate 89 can be attached to the thermal conduction bar 88 in other ways, only if the first thermal conduction plate 84 and the second thermal conduction plate 89 can be connected to each other through the thermal conduction bar 88. Material of the second thermal conduction plate 89 is similar as that of the first thermal conduction plate 84 and the thermal conduction bar 88. In the present invention, material of the second thermal conduction plate 89 is aluminum or copper. As the AC driven LED module 80 further includes the second thermal conduction plate 89, thus heat dissipating efficiency of the AC driven LED module 80 can be further increased. It is noted, in other alternative embodiments, the second thermal conduction plate 89 can be arranged adjacent to the peripheral surface 865 to contact the peripheral surface 865, for example. In still other alternative embodiments, either or both of the first thermal conduction plate 84 and the second thermal conduction plate 89, as well as the thermal conduction bar 88 can be connected to one another in other ways. For example, the first thermal conduction plate 84 and the thermal conduction bar 88 can be fixedly attached to each other via welding or screwing. The second thermal conduction plate 89 and the thermal conduction bar 88 can be integrally manufactured and connected to each other or fixedly attached to each other via welding. The first thermal conduction plate 84, the second thermal conduction plate 89, and the thermal conduction bar 88 can be integrally manufactured and connected to one another.

In summary, the AC driven LED module as described above, as the ceramic substrate has better heat dissipating property and insulation property, thus heat, which is generated by the AC driven LED chip and transferred to the ceramic substrate through the first thermal conduction plate, can be quickly dissipated to ambient environment by the ceramic substrate. In addition, as the AC driven LED module further includes a thermal conduction bar, and the thermal conduction bar has better thermal conductive property, thus shortage of insufficient thermal conductive property of the ceramic substrate can be compensated by the thermal conduction bar. Speed of the heat, which is generated by the AC driven LED chip, transferring from the AC driven LED chip to the ceramic substrate is accelerated, thus heat dissipating efficiency of the AC driven LED is further increased.

In addition, it is noted in the AC driven LED module as described above, the thermal conduction bar can be omitted when requirement for heat dissipating property is relatively less and a relatively larger contacting area of the first thermal conduction plate and the ceramic substrate is needed.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. An alternating current driven light emitting diode module, comprising an alternating current driven light emitting diode chip,
a first thermal conduction plate,
and a ceramic substrate,
wherein the alternating current driven light emitting diode chip is driven by alternating current, the first thermal conduction plate is arranged on the ceramic substrate, the alternating current driven light emitting diode chip is arranged on the first thermal conduction plate.

2. The alternating current driven light emitting diode module according to claim 1, wherein material of the ceramic substrate is aluminum oxide or aluminum nitride.

3. The alternating current driven light emitting diode module according to claim 1, further comprising a thermal conduction bar, wherein an end of the thermal conduction bar is connected to the first thermal conduction plate, an opposite other end of the thermal conduction bar extends into the ceramic substrate.

4. The alternating current driven light emitting diode module according to claim 3, wherein material of the first thermal conduction plate or the thermal conduction bar is metal.

5. The alternating current driven light emitting diode module according to claim 4, wherein metal is aluminum or copper.

6. The alternating current driven light emitting diode module according to claim 3, wherein the first thermal conduction plate and the thermal conduction bar are integrally manufactured and connected to each other, or the first thermal conduction plate and the thermal conduction bar are fixedly attached to each other via welding or screwing.

7. The alternating current driven light emitting diode module according to claim 3, wherein the ceramic substrate includes a bottom surface, a top surface opposite to the bottom surface, and a connection hole defined in the top surface and extending into the ceramic substrate, the first thermal conduction plate is arranged on the top surface, the thermal conduction bar extends into the ceramic substrate by cooperating with the connection hole.

8. The alternating current driven light emitting diode module according to claim 7, wherein a thermal adhesive is provided and filled between the thermal conduction bar and a sidewall of the connection hole.

9. The alternating current driven light emitting diode module according to claim 3, wherein the ceramic substrate includes a bottom surface, a top surface opposite to the bottom surface, and a connection hole defined in the top surface and extending through the bottom surface, the first thermal conduction plate is arranged on the top surface, the connection hole is a step hole, a portion of the hole with wider diameter is located adjacent to bottom surface, the thermal conduction bar is moved toward the bottom surface and inserted into the connection hole, and is further connected to the first thermal conduction plate after inserted into the connection hole.

10. The alternating current driven light emitting diode module according to claim 9, wherein a thermal adhesive is provided and filled between the thermal conduction bar and a sidewall of the connection hole.

11. The alternating current driven light emitting diode module according to claim 1, wherein the alternating current driven light emitting diode module further includes a thermal conduction bar, an end of the thermal conduction bar is connected to the first thermal conduction plate, the ceramic substrate is formed on the first thermal conduction plate and covers an opposite other end of the thermal conduction bar by injection molding.

12. The alternating current driven light emitting diode module according to claim 11, wherein the end of the thermal conduction bar covered by the ceramic substrate includes a thermal diffusion portion.

13. The alternating current driven light emitting diode module according to claim 12, wherein the thermal diffusion portion covered by the ceramic substrate is bent.

14. The alternating current driven light emitting diode module according to claim 3, wherein the alternating current driven light emitting diode module further includes a second thermal conduction plate, the ceramic substrate includes a top surface, a bottom surface opposite to the top surface, and a peripheral surface adjoining the top surface and the bottom surface, the first thermal conduction plate is arranged on the top surface, the second thermal conduction plate is arranged adjacent to the bottom surface or the peripheral surface, the thermal conduction bar is connected to the first thermal conduction plate and the second thermal conduction plate.

15. The alternating current driven light emitting diode module according to claim 14, wherein material of the first thermal conduction plate, the thermal conduction bar, and the second thermal conduction plate is metal.

16. The alternating current driven light emitting diode module according to claim 15, wherein metal is aluminum or copper.

17. The alternating current driven light emitting diode module according to claim 14, wherein the first thermal conduction plate, the second thermal conduction plate, and the thermal conduction bar are integrally manufactured and connected to one another, or the first thermal conduction plate, the second thermal conduction plate, and the thermal conduction bar are fixedly attached to one another via welding or screwing.
